# DEMANDE DE BREVET EUROPEEN

(11) **EP 2 586 890 A1**
(43) Date de publication de la demande: **01.05.2013**
(21) Numéro de dépôt: 11187034.1
(22) Date de dépôt: 28.10.2011
(51) Int. Cl.: C23C 16/44, C23C 16/455

(54) **Canalisation d'évacuation de gaz et procédé d'évacuation associé**

(71) Demandeur: Adixen Vacuum Products, 74000 Annecy (FR)
(72) Inventeur: Neel, Thierry, 74000 Annecy (FR)
(74) Mandataire: Croonenbroek, Thomas Jakob

(57) **Abrégé**

Les modes de réalisation de la présente invention décrivent une canalisation d'évacuation de gaz comprenant une première voies d'évacuation et au moins une deuxième voie d'évacuation destinées à être connectées respectivement à une première et à au moins une deuxième pompes à vide d'une part et à une sortie d'un réacteur d'autre part dans laquelle la première et au moins la deuxième voies d'évacuation comprennent des premiers et au moins des deuxièmes moyens d'injection d'un gaz inerte dont la direction de l'injection est respectivement orientée à l'opposé du sens d'aspiration des pompes à vide.

## Description

La présente invention concerne l'évacuation des gaz d'un réacteur et plus particulièrement l'évacuation des résidus de gaz réactifs en sortie d'un réacteur chimique tel que le réacteur d'un équipement de dépôt de couches atomiques.

Le fonctionnement habituel d'un équipement de dépôt en couche atomique selon l'état de la technique est décrit ci-après. Deux gaz réactifs G1 et G2 sont introduits séquentiellement dans un réacteur dans lequel se trouve un substrat (« wafer » en anglais) afin de permettre le dépôt d'une couche atomique sur le substrat. Une haute température est maintenue dans le réacteur par des éléments chauffants. Le résidu de gaz réactif (G1 ou G2) est évacué au travers d'une canalisation d'évacuation située en sortie de réacteur vers une pompe à vide.
Le problème avec une telle méthode est que les deux gaz réactifs G1 et G2 peuvent être mélangés au niveau de la pompe à vide. Un tel mélange peut produire des réactions chimiques conduisant à la formation de particules solides et de poudres dans la pompe à vide qui permet d'évacuer les gaz G1 et G2. Les particules solides et les poudres s'accumulant dans la pompe à vide peuvent conduire à une panne et/ou à une détérioration prématurée de la pompe à vide impactant par là même le coût de fabrication global des substrats.
Afin de surmonter ce problème, les solutions de l'état de la technique correspondent à l'utilisation de deux pompes à vide distinctes, chacune étant dédiée à un gaz réactif. La transmission vers l'une ou l'autre des pompes à vide étant réalisée par un système de vannes mécaniques à l'entrée de la canalisation d'évacuation dirigeant le gaz réactif vers l'une ou l'autre des voies d'évacuation de la canalisation auxquelles sont connectées les pompes à vide.
Néanmoins, avec de telles solutions, le mélange des gaz réactifs peut se produire au niveau des vannes mécaniques, entraînant le dépôt d'une couche de sous-produit au niveau des vannes ce qui peut perturber leur fonctionnement et conduire à une panne.
Le but de l'invention est donc de proposer un dispositif permettant d'éviter un mélange des gaz réactifs au niveau des éléments mécaniques en mouvement afin d'empêcher la formation de sous-produits pouvant conduire à une panne de fonctionnement et permettant également une orientation du gaz réactif d'une voie d'évacuation vers une autre voie d'évacuation de manière plus rapide et donc plus adaptée aux procédés pulsés tels que le procédé de dépôt en couches atomiques.

Ainsi, le dispositif selon la présente invention est une canalisation d'évacuation de gaz comprenant une première voie d'évacuation et au moins une deuxième voie d'évacuation destinées à être connectées respectivement à une première pompe à vide et à au moins une deuxième pompe à vide d'une part et à une sortie d'un réacteur d'autre part dans laquelle la première et au moins la deuxième voie d'évacuation comprennent des premiers et au moins des deuxièmes moyens d'injection d'un gaz inerte dont la direction de l'injection est respectivement orientée à l'opposé du sens d'aspiration des pompes à vide.
On entend par gaz inerte un gaz inerte unique ou un mélange de gaz inertes. Le gaz inerte peut être par exemple de l'azote N₂, de l'Argon Ar et/ou de l'hélium He.
Selon un autre aspect de la présente invention, la canalisation comprend un tronc central mettant en communication d'une part la sortie du réacteur et d'autre part la première et au moins la deuxième voies d'évacuation, la première et au moins la deuxième voies d'évacuation ayant des conductances du même ordre de grandeur.
Selon un aspect additionnel de la présente invention, les voies d'évacuation sont au nombre de deux et le tronc central comprend d'une part une partie interne en communication avec la première voie d'évacuation et d'autre part une partie périphérique séparée de la partie interne par une paroi, en communication avec la deuxième voie d'évacuation.
Selon un aspect supplémentaire de la présente invention, les conductances respectives de la partie interne et de la partie périphérique du tronc central sont du même ordre de grandeur.
Selon un autre aspect de la présente invention, les premiers moyens d'injection d'un gaz inerte sont situés dans l'axe de la partie interne du tronc central et sont orientés vers la sortie du réacteur, tandis que les deuxièmes moyens d'injection d'un gaz inerte sont situés sur le pourtour de la partie périphérique du tronc central, et sont orientés sensiblement vers le centre de la section du tronc central.
La présente invention a également pour objet un procédé d'évacuation d'un premier et d'au moins un deuxième gaz réactifs issus d'un réacteur par une canalisation d'évacuation, le premier et au moins le deuxième gaz réactifs étant évacués de manière séquentielle par une première et au moins une deuxième voies d'évacuation connectées à une première et à au moins une deuxième pompes à vide, dans lequel l'orientation de la circulation d'un gaz réactif vers l'une des voies d'évacuation est contrôlée par l'injection d'un gaz inerte sensiblement en sens opposé au sens d'aspiration des pompes à vide respectives.
Selon un autre aspect de la présente invention, l'injection de gaz inerte est réalisée à l'entrée d'une au moins des première et deuxième voies d'évacuation.
Selon un aspect additionnel de la présente invention, les premier et au moins deuxième gaz réactifs issus du réacteur sont reçus séquentiellement, et les première et au moins deuxième pompes à vide sont dédiées respectivement au premier et au moins deuxième gaz réactif de sorte qu'un gaz inerte est injecté au niveau de la première voie d'évacuation lorsque le gaz réactif à évacuer est destiné à la deuxième pompe à vide et qu'un gaz inerte est injecté au niveau de la deuxième voie d'évacuation lorsque le gaz réactif à évacuer est destiné à la première pompe à vide.
Selon un aspect supplémentaire de la présente invention, les premier et au moins deuxième gaz réactifs issus du réacteur sont reçus alternativement, de sorte que l'injection d'un gaz inerte au niveau des voies d'évacuation est aussi réalisée de manière alternative.
Selon un autre aspect de la présente invention, la quantité de gaz inerte injectée est la même pour les deux séquences de l'alternance et est calculée pour obtenir une concentration de 20% de gaz réactif dans le mélange gazeux au niveau de la pompe à vide, le mélange gazeux au niveau de la pompe à vide étant composé de gaz réactif et de gaz inerte injecté.
D'autres caractéristiques et avantages de l'invention apparaîtront dans la description qui va maintenant en être faite, en référence aux dessins annexés qui en représentent, à titre indicatif mais non limitatif, un mode de réalisation possible.
Sur ces dessins:
- la figure 1 représente un schéma d'un premier mode de réalisation d'une canalisation d'évacuation selon la présente invention;
- la figure 2 représente un schéma du premier mode de réalisation d'une canalisation d'évacuation selon la présente invention lorsque les premiers moyens d'injection de gaz inerte sont activés;
- la figure 3 représente un schéma d'un deuxième mode de réalisation d'une canalisation d'évacuation selon la présente invention;
- la figure 4 représente un schéma d'une vue en coupe transversale de la canalisation au niveau de l'entrée de la canalisation pour le deuxième mode de réalisation de la présente invention;
- la figure 5 représente un schéma d'une première étape de fonctionnement du deuxième mode de réalisation d'une canalisation d'évacuation selon la présente invention lorsque les premiers moyens d'injection de gaz inerte sont activés;
- la figure 6 représente un schéma d'une deuxième étape de fonctionnement du deuxième mode de réalisation d'une canalisation d'évacuation selon la présente invention lorsque les deuxièmes moyens d'injection de gaz inerte sont activés;
- la figure 7 représente un schéma d'une vue en coupe transversale de la canalisation au niveau de l'entrée de la canalisation et la direction du gaz inerte lorsque les deuxièmes moyens d'injection sont activés.

Dans le cadre de la présente invention, le terme « conductance » d'une canalisation est le quotient du flux divisé par la différence de pression en amont et en aval de la canalisation et correspond à la facilité d'écoulement d'un fluide dans la canalisation.

Les modes de réalisation de la présente invention concernent l'utilisation d'un gaz inerte au niveau d'une canalisation d'évacuation de gaz réactif issu d'un réacteur, par exemple un réacteur de dépôt de couches atomiques, comprenant au moins deux voies d'évacuation afin d'orienter le gaz réactif à évacuer vers l'une des voies d'évacuation.

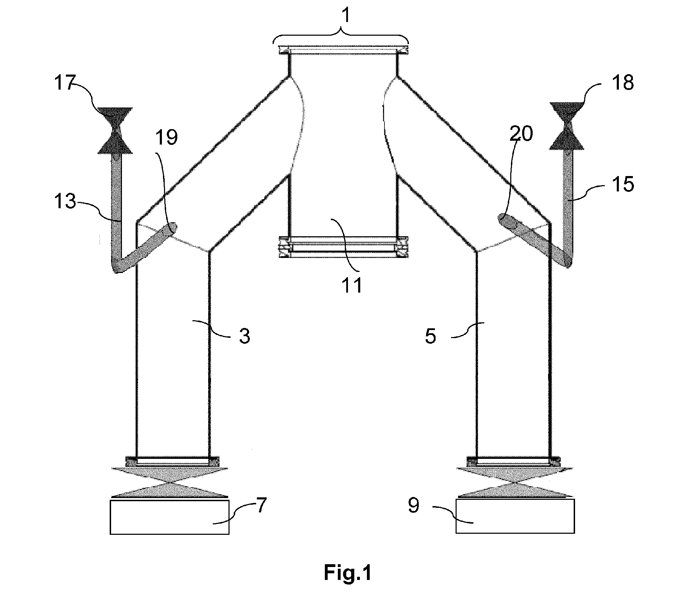

La figure 1 représente un premier mode de réalisation d'une canalisation d'évacuation.
La canalisation comprend une entrée 1 destinée à être connectée à la sortie d'un réacteur afin de recevoir les résidus de deux gaz réactifs, ou de deux mélanges différents de gaz réactifs, issus du réacteur, deux voies d'évacuation 3 et 5 reliées chacune à une pompe à vide 7 et 9 et un tronc central 11 reliant l'entrée 1 de la canalisation aux deux voies d'évacuation 3 et 5. Les voies d'évacuation étant réalisées de manière à obtenir une conductance, par exemple en ayant des dimensions similaires et une capacité de pompage similaire ayant le même ordre de grandeur.
De plus, chaque voie d'évacuation comprend respectivement des premiers et deuxièmes moyens d'injection d'un gaz inerte 13 et 15. Ces moyens d'injections 13 et 15 peuvent par exemple comprendre une première 17 et une deuxième 18 vanne pour laisser passer ou bloquer le gaz inerte et une première 19 et une deuxième 20 buse d'injection pour diffuser le gaz inerte dans la direction choisie, en sens opposé à la direction de pompage (c'est à dire à contre-sens du sens de propagation du gaz réactif dans la voie d'évacuation).

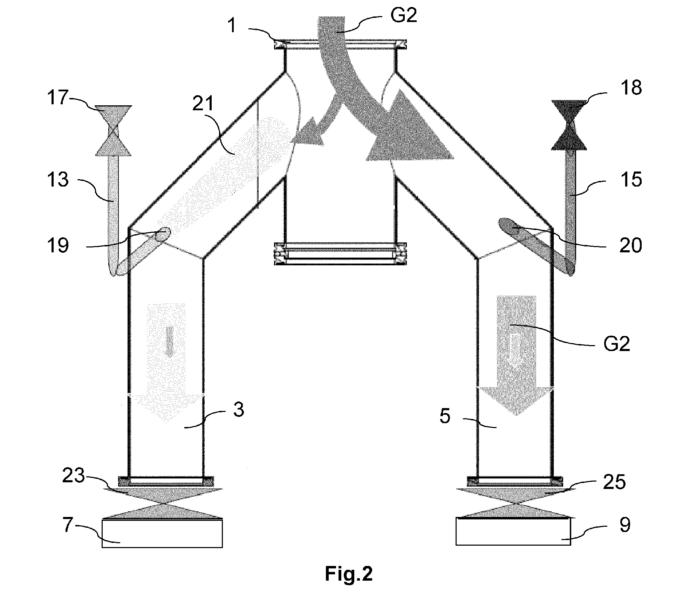

Ainsi, l'injection de gaz inerte 21 à contre-sens dans l'une des voies d'évacuation permet de diriger le gaz réactif vers l'autre voie d'évacuation comme représenté sur la figure 2. Lorsque le deuxième gaz G2 est reçu au niveau de l'entrée 1 de la canalisation, les premiers moyens d'injection 13 de gaz inerte 21 de la première voie d'évacuation 3 sont activés (par l'ouverture de la première vanne 17) pour contraindre les résidus de gaz réactif G2 à se diriger vers la deuxième voie d'évacuation 5 afin d'être transmis à la deuxième pompe à vide 9, cette dernière étant dédiée au pompage du gaz réactif G2. Les deuxièmes moyens d'injection 15 de gaz inerte 21 de la deuxième voie d'évacuation 5 restent inactivés (deuxième vanne 18 fermée). Le gaz inerte peut être par exemple de l'azote N₂, de l'argon Ar ou de l'hélium He.
Lorsque le gaz G1 est reçu à l'entrée 1 de la canalisation, les deuxièmes moyens d'injection 15 d'un gaz inerte 21 de la deuxième voie d'évacuation 5 sont activés, alors que les moyens d'injection 13 d'un gaz inerte 21 de la première voie d'évacuation 3 sont désactivés. Le gaz G1 est ainsi dirigé vers la première pompe à vide 7 dédiée au pompage du gaz G1.
En pratique, les deux gaz G1 et G2 sont généralement injectés alternativement dans le réacteur de sorte que l'activation des premiers et deuxièmes moyens d'injection de gaz inerte 13 et 15 est également réalisée de façon alternative en fonction du gaz réactif G1 ou G2 présent dans le réacteur.
D'autre part, la quantité de gaz inerte 21 injectée peut être réglée en fonction de la quantité de gaz réactif G1 ou G2 à évacuer et de la concentration de gaz réactif G1 ou G2 désirée au niveau de la pompe à vide 7 ou 9. Avantageusement, la quantité de gaz inerte 21 est la même pour les deux séquences d'injection de l'alternance de manière à ne pas modifier la pression à l'intérieur du réacteur et de la canalisation. La quantité de gaz inerte injectée est calculée pour obtenir une concentration de 20% de gaz réactif G1 ou G2 dans le mélange gazeux au niveau de la pompe à vide, le mélange gazeux au niveau de la pompe à vide étant composé de gaz réactif G1, G2 et de gaz inerte injecté 21. On considère que la concentration en sortie du réacteur du gaz réactif G1 ou G2 est de 100%.
Si cela est nécessaire, en fonction du système de pompage, cette concentration de gaz réactif G1 ou G2 au niveau de la pompe à vide peut être réduite à 1%.
De plus, selon un mode de réalisation, les premiers et deuxièmes moyens d'injection 13 et 15 ne bloquent pas totalement le passage du gaz inerte 21 lorsqu'ils sont inactifs, mais sont mis dans un mode veille dans lequel une faible quantité de gaz inerte 21 continue à être injectée pour empêcher la formation de dépôt sur les buses d'injection 19 et 20 du gaz inerte, protégeant ainsi les buses d'injection 19 et 20.
Par ailleurs, des vannes 23 et 25 sont situées à la sortie des voies d'évacuation 3 et 5 et à l'entrée des pompes à vide 7 et 9. Ces vannes 23 et 25 sont des vannes automatiques qui restent ouvertes en permanence en fonctionnement normal, et sont fermées en cas de panne de la pompe à vide correspondante afin d'isoler la pompe à vide défaillante de la canalisation.
De plus, seules deux voies d'évacuation sont représentées sur les figures 1 et 2, mais une canalisation comprenant un nombre plus important de voies d'évacuation (afin d'évacuer un nombre plus important de gaz réactifs) peut aussi être réalisée. Dans un tel cas, les moyens d'injection d'un gaz inerte des différentes voies d'évacuation, excepté la voie connectée à la pompe à vide dédiée au gaz réactif considéré, seront activés, contraignant ainsi le gaz réactif à se diriger vers la pompe à vide dédiée.

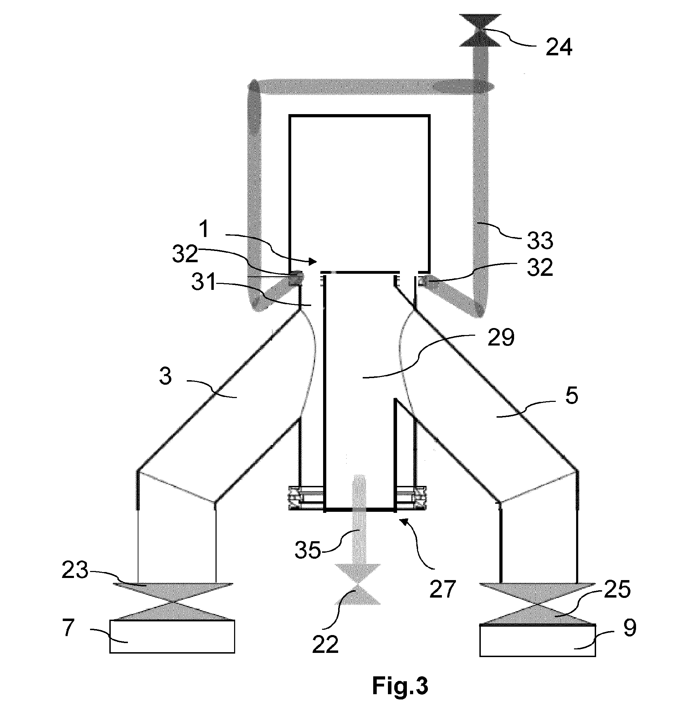

La figure 3 présente un deuxième mode de réalisation de la présente invention dans le cas où le nombre de voies d'évacuation est égal à 2. Dans ce deuxième mode de réalisation, la différence par rapport à la canalisation présentée précédemment concerne la configuration du tronc central 27. Cette configuration correspond à un premier tube, connecté à la deuxième voie d'évacuation 5 dont la section est inférieure à la section de l'entrée 1 de la canalisation et formant la partie interne 29 du tronc central 27 et un deuxième tube, connecté à la première voie d'évacuation 3 dont la section correspond à la section de l'entrée 1 de la canalisation et formant la partie périphérique 31 du tronc central 27. Les sections de la partie interne 29 et de la partie périphérique sont calculées de manière à obtenir des conductances du même ordre de grandeur entre l'entrée 1 de la canalisation et les voies d'évacuation respectives 3 et 5.

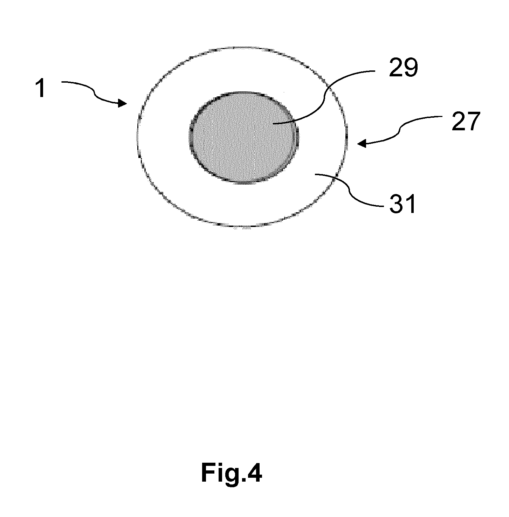

La figure 4 représente une vue en coupe transversale de la canalisation au niveau de son entrée 1 dans laquelle les parties interne 29 et périphérique 31 du tronc central 2 7 ont une section circulaire.
Néanmoins, la présente invention peut également s'appliquer à des sections de forme différente comme par exemple des sections ovales, voir rectangulaires ou carrées.
Comme pour le mode de réalisation précédent, des premiers et deuxièmes moyens d'injection de gaz inerte 33 et 35 sont utilisés afin d'orienter les résidus de gaz réactifs G1 ou G2 issus du réacteur vers l'une ou l'autre des voies d'évacuation pour être transmis à la pompe à vide dédiée, 7 ou 9.

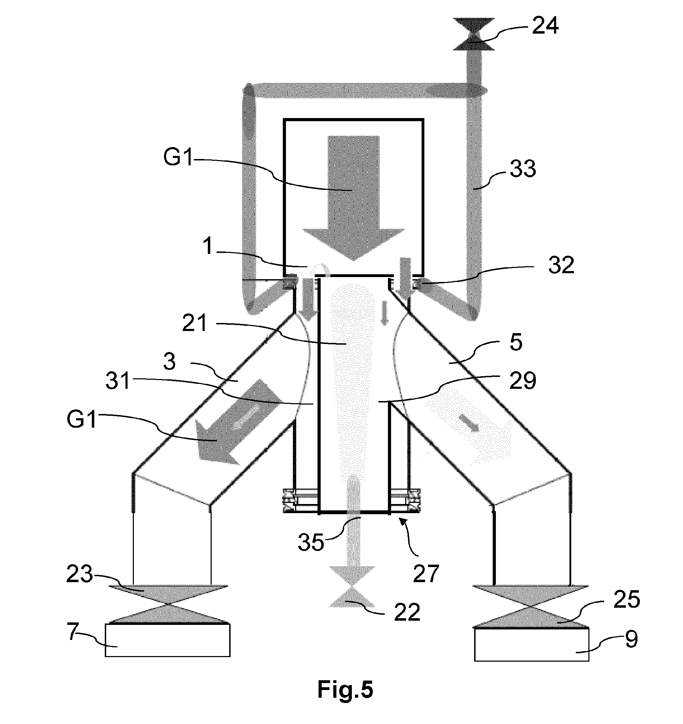

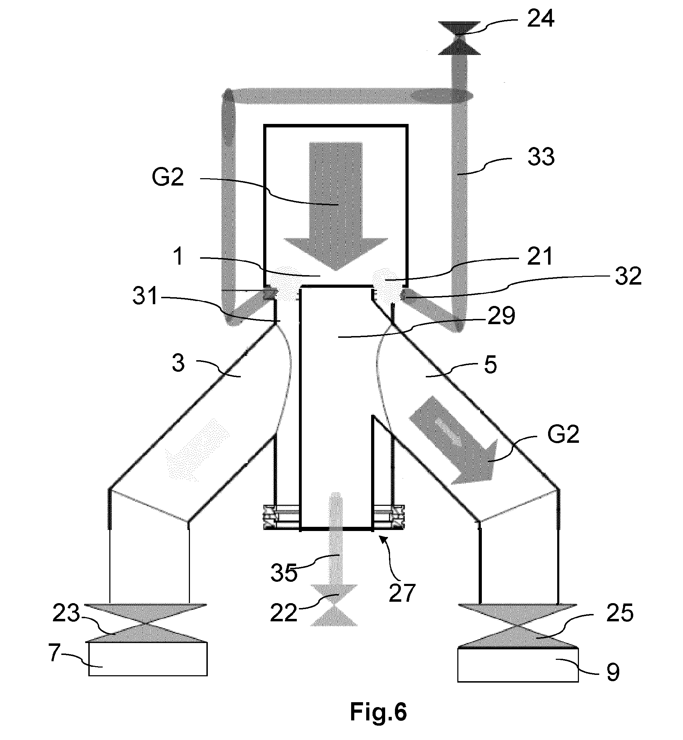

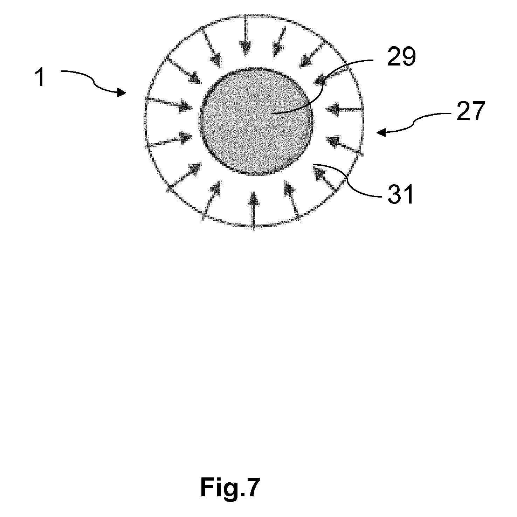

Les premiers moyens d'injection de gaz inerte 33 de la partie périphérique 31 sont régulièrement répartis sur le pourtour de la partie périphérique 31 (par exemple en utilisant un ensemble de buses d'injection 32 reliées à une arrivée de gaz inerte contrôlée par une vanne 24) au niveau de l'entrée 1 de la canalisation. Les moyens d'injection de gaz inerte 33 sont orientés vers le centre de l'entrée 1 de la canalisation, de manière à créer un jet annulaire, légèrement conique, comme représenté sur les figures 6 et 7. La figure 7 représente l'orientation de l'injection du gaz inerte au niveau de l'entrée 1 représentée sur la figure 4.
Ainsi, lorsque le deuxième gaz réactif G2 destiné à la pompe à vide 9 connectée à la deuxième voie d'évacuation 5 reliée à la partie interne 29 du tronc central 27 est reçu en entrée 1 de la canalisation, les moyens d'injection de gaz inerte 33 de la partie périphérique 31 sont activés (les moyens d'injection de gaz inerte 35 de la partie interne 29 restant inactivés) de manière à diriger le deuxième gaz réactif G2 vers la partie interne 29 du tronc central 27 et par conséquence vers la pompe à vide 9 correspondante.
Les deuxièmes moyens d'injection de gaz inerte 35 de la partie interne 29 du tronc central 27 sont situés dans l'axe de la partie interne 29 et à l'extrémité opposée à l'entrée 1 de la canalisation et sont orientés vers l'entrée 1 comme représenté sur la figure 5.
Ainsi, lorsque le premier gaz réactif G1 destiné à la pompe à vide 7 connectée à la première voie d'évacuation 3 reliée à la partie périphérique 31 du tronc central 27 est reçu en entrée 1 de la canalisation, ces moyens d'injection de gaz inerte 35 sont activés par l'ouverture d'une vanne 22 (les moyens d'injection de gaz inerte 33 de la partie périphérique 31 restant inactivés par la fermeture de la vanne 24) de manière à empêcher le gaz réactif G1 de rentrer dans la partie interne 29 et à le forcer à aller dans la voie d'évacuation 3 liée à la partie périphérique 31 du tronc central 27.

L'utilisation d'un gaz inerte 21 injecté constitue donc un écran gazeux permettant de bloquer l'entrée de la voie d'évacuation sélectionnée vis à vis d'un gaz réactif, et par conséquence d'orienter un gaz réactif dans la voie d'évacuation qui lui est dédiée sans avoir besoin de vannes ou autres éléments mécaniques, ces derniers pouvant être détériorés par interaction avec les gaz réactifs. Les modes de réalisation de la présente invention permettent donc d'éviter l'utilisation de parties mécaniques pouvant se bloquer ou se boucher, améliorant ainsi la durée de vie de la canalisation tout en réduisant sa maintenance. De plus, le changement d'orientation du gaz réactif d'une voie d'évacuation vers une autre peut se faire de manière plus rapide par rapport aux solutions de l'état de la technique. Enfin, les modes de réalisation de la présente invention permettent une dilution constante du gaz réactif en amont du système de pompage, facilitant ainsi son traitement.

## Revendications

1. Canalisation d'évacuation de gaz comprenant une première voie d'évacuation (3) et au moins une deuxième (5) voie d'évacuation destinées à être connectées respectivement à une première pompe à vide (7) et à au moins une deuxième pompe à vide (9) d'une part et à une sortie d'un réacteur d'autre part, dans laquelle la première (3) et au moins la deuxième (5) voies d'évacuation comprennent des premiers (13; 33) et au moins des deuxièmes (15; 35) moyens d'injection d'un gaz inerte (21) dont la direction de l'injection est respectivement orientée à l'opposé du sens d'aspiration des pompes à vide (7, 9).

2. Canalisation d'évacuation de gaz selon la revendication 1, comprenant un tronc central (11; 27) mettant en communication d'une part la sortie du réacteur et d'autre part la première (3) et au moins la deuxième (5) voies d'évacuation, la première (3) et au moins la deuxième (5) voies d'évacuation ayant des conductances du même ordre de grandeur.

3. Canalisation d'évacuation selon la revendication 2, dans laquelle les voies d'évacuation (3, 5) sont au nombre de deux et dans laquelle le tronc central (27) comprend d'une part une partie interne (29) en communication avec la deuxième voie d'évacuation (5) et d'autre part une partie périphérique (31) séparée de la partie interne (29) par une paroi et en communication avec la première voie d'évacuation (3).

4. Canalisation d'évacuation de gaz selon la revendication 3, dans laquelle les conductances respectives de la partie interne (29) et de la partie périphérique (31) du tronc central (27) sont du même ordre de grandeur.

5. Canalisation d'évacuation de gaz selon la revendication 4, dans laquelle les premiers moyens d'injection (33) d'un gaz inerte (21) sont situés dans l'axe de la partie interne (29) du tronc central (27) et sont orientés vers la sortie du réacteur tandis que les deuxièmes moyens d'injection (35) d'un gaz inerte (21) sont situés sur le pourtour de la partie périphérique (31) du tronc central (27), et sont orientés sensiblement vers le centre de la section du tronc central (27).

6. Procédé d'évacuation d'un premier (G1) et au moins un deuxième (G2) gaz réactifs issus d'un réacteur par une canalisation d'évacuation selon l'une des revendications 1 à 5, le premier (G1) et au moins le deuxième (G2) gaz réactifs étant évacués de manière séquentielle par une première (3) et au moins une deuxième (5) voies d'évacuation connectées respectivement à une première (7) et à au moins une deuxième (9) pompes à vide, dans lequel l'orientation de la circulation d'un gaz réactif (G1, G2) vers l'une des voies d'évacuation (3, 5) est contrôlée par l'injection d'un gaz inerte (21) sensiblement en sens opposé au sens d'aspiration des pompes à vides (7, 9) respectives.

7. Procédé d'évacuation selon la revendication 6, dans lequel l'injection d'un gaz inerte (21) est réalisée à l'entrée d'une au moins des première (3) et au moins deuxième (5) voies d'évacuation.

8. Procédé d'évacuation selon la revendication 6 ou 7, dans lequel les premier (G1) et au moins deuxième (G2) gaz réactifs issus du réacteur sont reçus séquentiellement, et dans lequel les première (7) et au moins deuxième (9) pompes à vide sont dédiées respectivement aux premier (G1) et au moins au deuxième (G2) gaz réactifs de sorte qu'un gaz inerte (21) est injecté au niveau de la première voie d'évacuation (3) lorsque le gaz réactif (G2) à évacuer est destiné à la deuxième pompe à vide (9) et qu'un gaz inerte (21) est injecté au niveau de la deuxième voie d'évacuation (5) lorsque le gaz réactif (G1) à évacuer est destiné à la première pompe à vide (7).

9. Procédé d'évacuation selon la revendication 8, dans lequel les premier (G1) et au moins le deuxième (G2) gaz réactifs issus du réacteur sont reçus alternativement dans la canalisation, de sorte que l'injection d'un gaz inerte (21) au niveau des voies d'évacuation (3, 5) est aussi réalisée de manière alternative.

10. Procédé d'évacuation selon la revendication 9, dans lequel la quantité de gaz inerte (21) injectée est la même pour les deux séquences de l'alternance et est calculée pour obtenir une concentration de 20% de gaz réactif (G1, G2) dans le mélange gazeux au niveau de la pompe à vide, le mélange gazeux au niveau de la pompe à vide étant composé de gaz réactif (G1, G2) et de gaz inerte injecté (21).
